**Europäisches Patentamt**

**European Patent Office**

**Office européen des brevets**

(11) Veröffentlichungsnummer: **0 655 838 A2**

# (12) EUROPÄISCHE PATENTANMELDUNG

(21) Anmeldenummer: **94117394.0**

(22) Anmeldetag: **04.11.94**

(51) Int. Cl.6: **H03K 19/003**

(30) Priorität: **26.11.93 DE 4340284**

(43) Veröffentlichungstag der Anmeldung:
**31.05.95 Patentblatt 95/22**

(84) Benannte Vertragsstaaten:
**DE FR GB IT**

(71) Anmelder: **TEMIC TELEFUNKEN
microelectronic GmbH
Theresienstrasse 2
D-74072 Heilbronn (DE)**

(72) Erfinder: **Genzel, Michael
Alter Steig 8
D-90574 Rosstal (DE)**

(74) Vertreter: **Maute, Hans-Jürgen, Dipl.-Ing.
TEMIC TELEFUNKEN microelectronic GmbH
Postfach 35 35
D-74025 Heilbronn (DE)**

(54) Verfahren zum Betrieb eines digitalen Logik-Halbleiterbauelements.

(57) Bei einem Verfahren zum Betrieb eines digitalen Logik-Halbleiterbauelements
a) kann das Logik-Halbleiterbauelement in Abhängigkeit der Umgebungstemperatur in mehreren Betriebsmodi getaktet betrieben werden,
b) wird jedem Betriebsmodus ein Takt mit jeweils unterschiedlicher Taktfrequenz zugeordnet,
c) wird jedem Betriebsmodus ein temperaturabhängiger Grenzwert mit jeweils unterschiedlicher Grenzwerttemperatur zugeordnet, bei dessen Erreichen ein Wechsel des Betriebsmodus vorgenommen wird, und
d) wird die Taktfrequenz beim Wechsel zu einem Betriebsmodus mit höherer Grenzwerttemperatur reduziert und beim Wechsel zu einem Betriebsmodus mit niedrigerer Grenzwerttemperatur erhöht.

FIG.1

EP 0 655 838 A2

Digitale Logik-Halbleiterbauelemente (beispielsweise Microcontroller) werden in vielfältiger Weise eingesetzt - beispielsweise zur Ansteuerung peripherer Geräte. An diese - oftmals getaktet betriebenen - Logik-Halbleiterbauelemente werden je nach Umgebungsbedingungen ganz spezielle Anforderungen gestellt. Hier spielt insbesondere die Temperatur eine wichtige Rolle, da die Auswahl der Bauelement-Exemplare unter anderem anhand der vom Kunden spezifizierten maximal zulässigen Umgebungstemperatur erfolgt; daher müssen bei hohen Temperaturanforderungen oder bei stark schwankenden Umgebungstemperaturen - beispielsweise im Kfz-Bereich - hierfür optimierte, teuere Bauelemente verwendet werden.

Hohe Umgebungstemperaturen treten jedoch meist lediglich unter extremen Umweltbedingungen während einer geringen Zeitspanne innerhalb der Lebensdauer der vom Logik-Halbleiterbauelement angesteuerten Geräte auf, so daß der Einsatz von "Hochtemperatur"-Bauelementen unter wirtschaftlichen Aspekten und Kostengesichtspunkten nicht gerechtfertigt ist.

Der Erfindung liegt die Aufgabe zugrunde, ein Verfahren anzugeben, mit dem der Temperaturbereich für den Einsatz konventioneller Logik-Halbleiterbauelemente wesentlich erweitert werden kann.

Diese Aufgabe wird erfindungsgemäß durch die Merkmale im Kennzeichen des Patentanspruchs 1 gelöst. Vorteilhafte Weiterbildungen des Verfahrens ergeben sich aus den Unteransprüchen.

Beim vorgestellten Verfahren werden mehrere verschiedene Betriebsmodi M für das digitale Logik-Halbleiterbauelement definiert: jedem Betriebsmodus M wird ein Prozessortakt TA mit bestimmter Taktfrequenz f und eine Grenzwerttemperatur $T_G$ zugeordnet, bei deren Erreichen ein Wechsel des Betriebsmodus M vorgenommen wird. In den Betriebsmodi M mit höherer Grenzwerttemperatur $T_G$ - oder was gleichbedeutend ist, mit einer höheren zulässigen Umgebungstemperatur $T_U$ - wird der Funktionsumfang des Rechenprogramms bzw. der Software reduziert; da die Programmlaufzeit bei einer Reduzierung des Funktionsumfangs geringer ist, kann die Taktfrequenz f in den Betriebsmodi mit höherer zulässiger Umgebungstemperatur $T_U$ reduziert werden - insbesondere so weit, daß sich wieder die ursprüngliche Programmlaufzeit ergibt. Die Grenzwerttemperatur $T_G$ der Betriebsmodi M wird von der jeweils vorgegebenen bzw. gewählten Taktfrequenz f festgelegt, da die zulässige Umgebungstemperatur $T_U$ für das Logik-Halbleiterbauelement und damit auch die Grenzwerttemperatur $T_G$ jedes Betriebsmodus M von der Verlustleistung $P_V$ und diese wiederum von der Taktfrequenz f abhängt. Bei einem linearen Zusammenhang zwischen der Verlustleistung $P_V$ und der Taktfrequenz f erhält man:

$$P_V = a + b \cdot f \qquad (1),$$

wobei a und b vom Herstellungsprozeß des Halbleiterbauelements abhängige Konstanten sind.

Bei gegebenem thermischen Übergangswiderstand $R_{th}$ und gegebener maximaler Sperrschichttemperatur $T_S$ des Logik-Halbleiterbauelements ist eine Beziehung zwischen der maximal zulässigen Umgebungstemperatur $T_U$ und der Verlustleistung $P_V$ gegeben:

$$T_U = T_S - P_V \cdot R_{th} \qquad (2).$$

Mit Gleichung (1) ergibt sich somit ein linearer Zusammenhang zwischen der maximal zulässigen Umgebungstemperatur $T_U$ und der Taktfrequenz f:

$$\begin{aligned} T_U &= T_S - a \cdot R_{th} - b \cdot R_{th} \cdot f \\ &= \text{Konstante} \quad - b \cdot R_{th} \cdot f \end{aligned} \qquad (3).$$

Für die Grenzwerttemperatur $T_G$ ($T_G \leq T_U$) erhält man hieraus die Relation:

$$T_G \leq \text{Konstante} - b \cdot R_{th} \cdot f \qquad (4).$$

Anhand der Gleichungen (1) bis (3) erkennt man, daß sich durch Verringerung der Taktfrequenz f eine deutliche Reduzierung der Verlustleistung $P_V$ und damit eine wesentlich höhere zulässige Umgebungstemperatur $T_U$ für das Logik-Bauelement ergibt. Bei vorgegebener Taktfrequenz f kann die Grenzwerttemperatur $T_G$ innerhalb des von Gleichung (4) festgelegten Bereichs gewählt werden; vorzugsweise wird diese bei gegebener zulässiger Umgebungstemperatur $T_U$ als maximal mögliche Temperatur gewählt ($T_G = T_U$). Durch die Reduzierung der Taktfrequenz und damit der Verlustleistung wird die maximal zulässige Umgebungstemperatur der Logik-Halbleiterbauelemente erhöht, so daß selbst für hohe Temperaturanforderungen preisgünstige konventionelle Logik-Halbleiterbauelemente eingesetzt werden können - es sind keine Sonderspezifikationen erforderlich. Weiterhin kann durch Reduktion der Verlustleistung bei gegebener Umgebungstemperatur die Sperrschichttemperatur herabgesetzt und damit die Lebensdauer der Logik-Halbleiterbauelemente deutlich gesteigert werden.

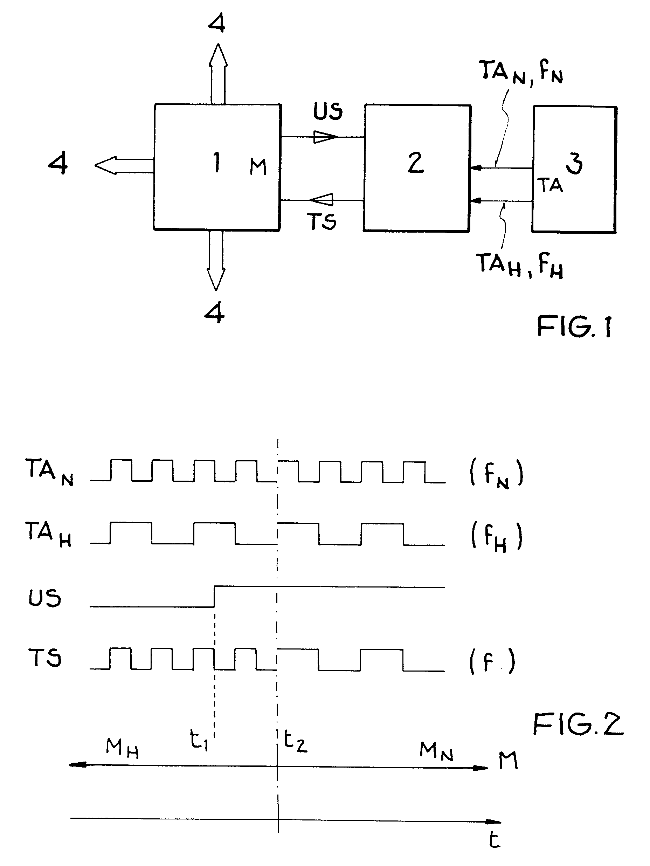

Das vorgestellte Verfahren wird im folgenden anhand der Zeichnung weiter erläutert. Hierzu zeigt Figur 1 ein Blockschaltbild mit den zum Betrieb des Logik-Halbleiterbauelements erforderlichen Komponenten und die Figur 2 ein Timing-Diagramm zur Erläuterung der Modus-Umschaltung.

Wie in der Figur 1 dargestellt, wird das die Geräte 4 ansteuernde digitale Logik-Halbleiterbauelement 1 vom den Prozessortakt TA erzeugenden Oszillator 3 über die Schaltlogik 2 mit dem Taktsignal TS beaufschlagt. Das Logik-Halbleiterbauelement 1 kann in zwei Betriebsmodi M betrieben werden: einem Normalmodus $M_N$ mit vollem Funktionsumfang und normaler (Betriebs-)Taktfrequenz $f_N$ sowie einem Hochtemperaturmodus $M_H$ mit reduziertem Funktionsumfang und reduzierter Taktfrequenz $f_H$.

Beim Erreichen der Grenzwerttemperatur wird durch das vom Logik-Halbleiterbauelement 1 erzeugte Umschaltsignal US - mittels der Schaltlogik 2 - der Oszillator 3 zwischen dem Takt $TA_N$ mit der höheren "Normal"-Taktfrequenz $f_N$ (Normalbetrieb) und dem Takt $TA_H$ mit der reduzierten "Hochtemperatur"-Taktfrequenz $f_H$ (Hochtemperaturbetrieb) umgeschaltet. Die Schaltlogik 2 koordiniert die flankensynchrone Umschaltung zwischen dem Takt $TA_N$ und dem Takt $TA_H$: gemäß Figur 2 wirkt sich das zum Zeitpunkt $t_1$ abgegebene Umschaltsignal US erst zum Zeitpunkt $t_2$ auf den Takt TA aus, da dann die beiden Takte $TA_N$ und $TA_H$ flankensynchron sind. Bei einem Ausführungsbeispiel - einem von einem Microcontroller gesteuerten Schaltgetriebe eines Kraftfahrzeugs - wird bei einer maximal zulässigen Umgebungstemperatur von 150 °C beim Überschreiten einer Grenzwerttemperatur $T_G$ von 125 °C vom Normalmodus $M_N$ mit der Taktfrequenz $f_N$ = 40 MHz in den Hochtemperaturmodus $M_H$ mit der Taktfrequenz $f_H$ = 20 MHz umgeschaltet.

**Patentansprüche**

1. Verfahren zum Betrieb eines digitalen Logik-Halbleiterbauelements, wobei
   a) das Logik-Halbleiterbauelement (1) in Abhängigkeit der Umgebungstemperatur ($T_U$) in mehreren Betriebsmodi (M) getaktet betrieben werden kann,
   b) jedem Betriebsmodus (M) ein Takt (TA) mit jeweils unterschiedlicher Taktfrequenz (f) zugeordnet wird,
   c) jedem Betriebsmodus (M) ein temperaturabhängiger Grenzwert mit jeweils unterschiedlicher Grenzwerttemperatur ($T_G$) zugeordnet wird, bei dessen Erreichen ein Wechsel des Betriebsmodus (M) vorgenommen wird, und
   d) die Taktfrequenz (f) beim Wechsel zu einem Betriebsmodus (M) mit höherer Grenzwerttemperatur ($T_G$) reduziert und beim Wechsel zu einem Betriebsmodus (M) mit niedrigerer Grenzwerttemperatur ($T_G$) erhöht wird.

2. Verfahren nach Anspruch 1, dadurch gekennzeichnet, daß die Takte (TA) der Betriebsmodi (M) von einem Oszillator (3) erzeugt werden, der das Logik-Halbleiterbauelement (1) mit einem Taktsignal (TS) der jeweiligen Taktfrequenz (f) beaufschlagt.

3. Verfahren nach Anspruch 1 oder 2, dadurch gekennzeichnet, daß der Wechsel des Betriebsmodus (M) vom Logik-Halbleiterbauelement (1) durch ein Umschaltsignal (US) initiiert wird, und daß mit dem Umschaltsignal (US) ein mit dem Logik-Halbleiterbauelement (1) und dem Oszillator (3) bidirektional verbundenes Schaltglied (2) beaufschlagt wird.

4. Verfahren nach Anspruch 3, dadurch gekennzeichnet, daß die Taktumschaltung beim Wechsel des Betriebsmodus (M) durch das Schaltglied (2) flankensynchron vorgenommen wird.

5. Verfahren nach einem der Ansprüche 1 bis 4, dadurch gekennzeichnet, daß die Grenzwerttemperatur ($T_G$) eines Betriebsmodus (M) in Abhängigkeit von der jeweiligen Taktfrequenz (f) des Betriebsmodus (M) gewählt wird.

6. Verfahren nach Anspruch 5, dadurch gekennzeichnet, daß die Grenzwerttemperatur ($T_G$) als die bei der Taktfrequenz (f) des Betriebsmodus (M) maximal noch zulässige Umgebungstemperatur ($T_U$) gewählt wird.

7. Verfahren nach einem der Ansprüche 1 bis 6, dadurch gekennzeichnet, daß das Logik-Halbleiterbauelement (1) in zwei verschiedenen Betriebsmodi (M) mit unterschiedlicher Taktfrequenz (f) betrieben wird.

8. Verfahren nach Anspruch 7, dadurch gekennzeichnet, daß die zwei Betriebsmodi (M) als Normalmodus ($M_N$) und Hochtemperaturmodus ($M_H$) definiert werden, und daß der Wechsel vom Normalmodus ($M_N$) mit der höheren Taktfrequenz ($f_N$) zum Hochtemperaturmodus ($M_H$) mit der niedrigeren Taktfrequenz ($f_N$) bei einer von der Taktfrequenz ($f_N$) des Normalmodus ($M_N$) abhängigen Grenzwerttemperatur ($T_G$) erfolgt.

9. Verfahren nach einem der Ansprüche 1 bis 8 zum Betrieb eines zur Ansteuerung von Geräten (4) im Kfz-Bereich verwendeten Microcontrollers (1).

FIG.1

FIG.2